# EUROPEAN PATENT APPLICATION

(11) **EP 4 839 069 A1**
(43) Date of publication of application: **11.11.2026**
(21) Application number: 24958927.6
(22) Date of filing: 30.10.2024
(51) Int. Cl.: H10K 59/38

(54) **DISPLAY PANEL AND DISPLAY DEVICE**

(71) Applicant: BOE Technology Group Co., Ltd., Beijing 100015 (CN); Yunnan Invensight Optoelectronics Technology Co., Ltd., Kunming, Yunnan 650211 (CN); Beijing BOE Technology Development Co., Ltd., Daxing District Beijing 100176 (CN)
(72) Inventor: YANG, Zongshun, Beijing 100176 (CN); ZHANG, Dacheng, Beijing 100176 (CN); LI, Yunlong, Beijing 100176 (CN); LIU, Wei, Beijing 100176 (CN); YANG, Shengji, Beijing 100176 (CN); HUANG, Yinhu, Beijing 100176 (CN); HE, Yonghong, Beijing 100176 (CN); YANG, Chao, Beijing 100176 (CN); HE, Baimei, Beijing 100176 (CN); FENG, Weixiong, Beijing 100176 (CN)
(74) Representative: Durán-Corretjer, S.L.P.
(86) International application number: PCT/CN2024/128488
(87) International publication number: WO 2026/090907

(57) **Abstract**

A display panel and a display device. The display panel may comprise a light-emitting substrate (1), a color film (3) and a lens layer (5). The light-emitting substrate (1) may comprise a base (101) and a light-emitting structure (26). The light-emitting structure (26) may emit initial light. The color film (3) may be disposed on the light-emitting substrate (1). The color film (3) may filter the initial light into multiple monochromatic lights of different colors. The lens layer (5) may be disposed on the side of the color film (3) away from the light-emitting substrate (1). The lens layer (5) may amplify the brightness of the multiple monochromatic lights and compensate for the brightness difference between the multiple monochromatic lights. The lens layer (5) outputs multiple amplified light rays of different colors. The brightness difference between the multiple amplified light rays is less than a preset difference.

## Description

### Technical Field

The present disclosure relates to, but is not limited to, the field of display technologies, and in particular to a display panel and a display device.

### Background

Organic Light-Emitting diode (OLED) displays are widely used in various display products because of their advantages such as self-illumination, low power consumption, high color gamut, wide viewing angle and short response time. In particular, silicon-based organic light-emitting micro-display panels (Micro-OLED), which have the characteristics such as small pixel size and high pixel density, are widely used in display products of Augmented Reality (AR) technology and Virtual Reality (VR) technology, as well as in the field of autonomous driving and the like.

Silicon-based organic light-emitting micro-display panels mostly adopt a structure combining white light-emitting devices with color filter layers (Color Film, CF) to realize full-color display. However, a transmittance of the color filter layer is only 20%, especially a transmittance to blue light is usually less than 20%, which is less than transmittances to red light and green light. This makes a brightness of blue light weak and affects the display effect. At present, the scheme of enhancing the brightness of blue light is not ideal, and it is easy to cause problems such as reduced service life.

### Summary

The following is a summary of subject matters described herein in detail. This summary is not intended to limit the protection scope of claims.

An embodiment of the present disclosure provides a display panel, which includes: a light-emitting substrate including a base substrate and a light-emitting structure that is configured to emit initial light; a color filter layer disposed on the light-emitting substrate, the color filter layer being configured to filter the initial light into a plurality of kinds of monochromatic light of different colors; and a lens layer disposed on a side of the color filter layer away from the light-emitting substrate. The lens layer is configured to amplify brightness of the plurality of kinds of monochromatic light and to compensate for brightness differences between the plurality of kinds of monochromatic light, the lens layer outputs a plurality of kinds of amplified light of different colors, and brightness differences between the plurality of kinds of amplified light are less than a preset difference.

In some exemplary embodiments, the lens layer includes a plurality of lenses arranged at intervals in a first direction, and the plurality of lenses include at least one first lens and at least one second lens. The first lens and the second lens are configured to transmit monochromatic light of different colors, a brightness amplification gain of the first lens is greater than a brightness amplification gain of the second lens, and the first direction is parallel to the light-emitting substrate.

In some exemplary embodiments, the plurality of lenses further include at least one third lens, and monochromatic light transmitted by the third lens is configured to have a different color from the monochromatic light transmitted by the first lens and the second lens. The brightness amplification gain of the first lens is greater than a brightness amplification gain of the third lens. Alternatively, the brightness amplification gain of the third lens is configured to be smaller than the brightness amplification gain of the second lens.

In some exemplary embodiments, an end surface of the first lens away from the light-emitting substrate is a first curved surface, an end surface of the second lens away from the light-emitting substrate is a second curved surface, and a curvature of the first curved surface is greater than a curvature of the second curved surface. Alternatively, a maximum dimension of the first lens in a second direction is configured to be larger than a maximum dimension of the second lens in the second direction, and the second direction is perpendicular to the light-emitting substrate. Alternatively, a maximum dimension of the first lens in the first direction is configured to be larger than a maximum dimension of the second lens in the first direction.

In some exemplary embodiments, the color filter layer includes a first color film layer configured to filter the initial light into a first monochromatic light, a second color film layer configured to filter the initial light into a second monochromatic light, and a third color film layer configured to filter the initial light into a third monochromatic light. An orthographic projection of the first lens on the base substrate is within an orthographic projection of the first color film layer on the base substrate. An orthographic projection of the second lens on the base substrate is within an orthographic projection of the second color film layer on the base substrate. An orthographic projection of the third lens on the base substrate is within an orthographic projection of the third color film layer on the base substrate.

In some exemplary embodiments, the first monochromatic light is configured to be blue light and the second monochromatic light is configured to be red light or green light. A light transmittance of the first color film layer is smaller than a light transmittance of the second color film layer, and brightness of the first monochromatic light is smaller than brightness of the second monochromatic light.

In some exemplary embodiments, the light-emitting structure includes a first electrode and a pixel definition layer disposed sequentially in a direction away from the base substrate, and the color filter layer is disposed on a side of the pixel definition layer away from the base substrate. The pixel definition layer is provided with a plurality of pixel openings, and a pixel opening of the plurality of pixel openings is configured to expose a portion of a surface of the first electrode. An orthographic projection of a lens of the plurality of lenses on the base substrate is within an orthographic projection of the pixel opening on the base substrate, and a center of the pixel opening and a center of the lens are collinear in a direction perpendicular to the base substrate.

In some exemplary embodiments, a minimum distance between the first lens and the second lens in the first direction is configured to be equal to a minimum distance between the first lens and the third lens in the first direction.

In some exemplary embodiments, the center of the pixel opening and a center of the first electrode are configured to be collinear in the direction perpendicular to the base substrate. A minimum distance between the first color film layer and the second lens in the first direction is configured to be equal to a minimum distance between the first color film layer and the third lens in the first direction.

In some exemplary embodiments, the center of the pixel opening and a center of the first electrode are non-collinear in the direction perpendicular to the base substrate. The plurality of pixel openings include a first opening, a second opening, and a third opening. The orthographic projection of the first lens on the base substrate is within an orthographic projection of the first opening on the base substrate. The orthographic projection of the second lens on the base substrate is within an orthographic projection of the second opening on the base substrate. The orthographic projection of the third lens on the base substrate is within an orthographic projection of the third opening on the base substrate. A spacing between a center of the first opening and a center of the second opening in the first direction is configured to be equal to a spacing between the center of the first opening and a center of the third opening in the first direction.

In some exemplary embodiments, the center of the pixel opening and a center of the first electrode are non-collinear in the direction perpendicular to the base substrate. The plurality of pixel openings include a first opening, a second opening, and a third opening. The orthographic projection of the first lens on the base substrate is within an orthographic projection of the first opening on the base substrate. The orthographic projection of the second lens on the base substrate is within an orthographic projection of the second opening on the base substrate. The orthographic projection of the third lens on the base substrate is within an orthographic projection of the third opening on the base substrate. The second opening and the third opening are disposed on two sides of the first opening in the first direction, and the second opening and the third opening are configured to be symmetrical about a center line of the first color film layer in the first direction. A minimum distance between the first color film layer and the second lens in the first direction is configured to be equal to a minimum distance between the first color film layer and the third lens in the first direction.

In some exemplary embodiments, a thickness of the first color film layer, a thickness of the second color film layer, and a thickness of the third color film layer are configured to sequentially increase. The brightness amplification gain of the first lens, the brightness amplification gain of the second lens, and the brightness amplification gain of the third lens are configured to sequentially increase. The thickness of the first color film layer is configured to be a maximum dimension of the first color film layer in a second direction. The thickness of the second color film layer is configured to be a maximum dimension of the second color film layer in the second direction. The thickness of the third color film layer is configured to be a maximum dimension of the third color film layer in the second direction. The second direction is perpendicular to the light-emitting substrate.

In some exemplary embodiments, a thickness difference between the first color film layer and the second color film layer is configured to be less than or equal to 0.8 microns. A thickness difference between the second color film layer and the third color film layer is configured to be less than or equal to 0.8 microns.

In some exemplary embodiments, a maximum dimension of the first lens in the first direction is a first width, a maximum dimension of the second lens in the first direction is a second width, and a maximum dimension of the third lens in the first direction is a third width. A difference between the first width and the second width is less than or equal to 1.5 microns, and a difference between the second width and the third width is configured to be less than or equal to 1.5 microns.

In some exemplary embodiments, a filling layer is further included, and the filling layer is located between the lens layer and the color filter layer.

In some exemplary embodiments, the filling layer is configured to compensate for a height difference between the first color film layer, the second color film layer, and the third color film layer. One end of the plurality of lenses close to the light-emitting substrate are located in a same plane parallel to the light-emitting substrate. Alternatively, the filling layer is configured to compensate for a height difference between the first lens, the second lens, and the third lens. Ends of the first lens, the second lens, and the third lens away from the light-emitting substrate are located in a same plane parallel to the light-emitting substrate.

In some exemplary embodiments, a refractive index of the filling layer is configured to be greater than a refractive index of the lens layer and less than a refractive index of the color filter layer.

In some exemplary embodiments, the filling layer is provided with a third curved surface recessed toward the light-emitting substrate. An orthographic projection of at least one lens of the plurality of lenses on the base substrate is configured to overlap with an orthographic projection of the third curved surface on the base substrate. The third curved surface is configured to gather monochromatic light transmitted through the filling layer toward the lens.

In some exemplary embodiments, a plurality of third curved surfaces are provided. The plurality of third curved surfaces are arranged in a direction parallel to the base substrate. The plurality of third curved surfaces are provided as a plurality of curved surfaces having different curvatures.

In some exemplary embodiments, at least one of the first color film layer, the second color film layer, and the third color film layer is provided with a fourth curved surface recessed toward the light-emitting substrate at an end surface away from the light-emitting substrate. The filling layer covers the fourth curved surface, and an orthographic projection of the fourth curved surface on the base substrate is configured to overlap with the orthographic projection of the third curved surface on the base substrate.

In some exemplary embodiments, one of the plurality of lenses is configured to cover the third curved surface, and is provided with a fifth curved surface matching the third curved surface at an end surface close to the light-emitting substrate.

In some exemplary embodiments, the fourth curved surface is disposed on the first color film layer. An end of the fourth curved surface close to the light-emitting substrate is configured to flush with ends of the second color film layer and the third color film layer away from the light-emitting substrate. A maximum dimension of a circumferential margin of the first color film layer in a direction perpendicular to the base substrate is a first thickness. The first thickness is configured to be larger than a thickness of the second color film layer and a thickness of the third color film layer.

In some exemplary embodiments, a height of the first lens, a height of the second lens, and a height of the third lens are configured to sequentially decrease. The brightness amplification gain of the first lens, the brightness amplification gain of the second lens, and the brightness amplification gain of the third lens are configured to sequentially decrease. The height of the first lens is configured to be a maximum dimension of the first lens in a direction perpendicular to the light-emitting substrate. The height of the second lens is configured to be a maximum dimension of the second lens in the direction perpendicular to the light-emitting substrate. The height of the third lens is configured to be a maximum dimension of the third lens in the direction perpendicular to the light-emitting substrate.

In some exemplary embodiments, a difference between a height of the first lens and a height of the second lens is less than or equal to 1 micron. A difference between the height of the second lens and a height of the third lens is less than or equal to 1 micron. A ratio of the brightness amplification gain of the first lens to the brightness amplification gain of the second lens is configured to be 1 to 1.5. A ratio of the brightness amplification gain of the second lens to the brightness amplification gain of the third lens is configured to be 1 to 1.5.

An embodiment of the present disclosure provides a display device which includes a display panel describe above.

After drawings and detailed description are read and understood, other aspects may be understood.

### Brief Description of Drawings

Accompanying drawings are used for providing further understanding of technical solutions of the present disclosure, constitute a portion of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, but are only intended to schematically describe contents of the present disclosure.
FIG. 1 is a schematic diagram of a structure of a display device;
FIG. 2 is a schematic diagram of a planar structure of a display device;
FIG. 3 is a schematic diagram of a cross-sectional structure of a display device;
FIG. 4 is an equivalent circuit diagram of a pixel driving circuit;
FIG. 5 is a schematic cross-sectional view of a display panel of the present exemplary embodiment;
FIG. 6 is a partially enlarged schematic view at A in FIG. 5;
FIG. 7 is a partially enlarged schematic view at B in FIG. 5;
FIG. 8 is a schematic cross-sectional view of another display panel of the present exemplary embodiment;
FIG. 9 is a top view of the display panel of FIG. 5;
FIG. 10 is a top view of another display panel of the present exemplary embodiment;
FIG. 11 is a schematic cross-sectional view of yet another display panel of the present exemplary embodiment;
FIG. 12 is a schematic cross-sectional view of another display panel of the present exemplary embodiment;
FIG. 13 is a schematic cross-sectional view of yet another display panel of the present exemplary embodiment;
FIG. 14 is a schematic diagram of another lens of the present exemplary embodiment;
FIG. 15 is a first schematic diagram of preparation of a color filter layer of the present exemplary embodiment;
FIG. 16 is a second schematic diagram of preparation of a color filter layer of the present exemplary embodiment; and
FIG. 17 is a schematic diagram of yet another display panel of the present exemplary embodiment.

### Detailed Description

The embodiments of the present disclosure will be described below with reference to the drawings in detail. Implementations may be embodied in multiple different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third" and the like in the specification are set not to form limits in numbers but only to avoid confusion between constituent elements. In the present disclosure, "a plurality of" represents two or more than two.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that involved apparatus or elements are required to have specific orientations or are structured and operated in the specific orientations but only to easily describe the present specification and simplify the description, and thus should not be understood as limitations on the present disclosure. The positional relationships between the constituent elements are changed as appropriate according to directions of the constituent elements described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, a detachable connection, or an integral connection. It may be a mechanical connection or a connection. It may be a direct connection, an indirect connection through a middleware, or an internal communication between two elements. Those of ordinary skills in the art may understand meanings of the aforementioned terms in the present disclosure according to situations.

In the specification, an "electrical connection" includes a case that constituent elements are connected together through an element with a certain electrical action. The "element with a certain electrical action" is not particularly limited as long as electrical signals between the connected constituent elements can be transmitted. Examples of the "element with a certain electrical action" not only include an electrode and a wiring, but also include a switching element such as a transistor, a resistor, an inductor, a capacitor, other elements with various functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a circle, oval, triangle, rectangle, trapezoid, pentagon, hexagon, or the like is not strictly defined, but may be an approximate circle, oval, triangle, rectangle, trapezoid, pentagon, hexagon, or the like. Some small deformations due to tolerances may exist, for example, chamfers, arc edges, and deformations, or the like may exist.

In the present disclosure, "about" and "approximate" means that a boundary is not defined strictly and a case within a range of process and measurement errors is allowed. In the present disclosure, "substantially the same" refers to a case where numerical values differ by less than 10%. "Symmetry" in the present disclosure means that a boundary is not defined strictly and a case where approximate symmetry within a range of process and measurement errors is allowed.

In some exemplary embodiments, a display panel includes a light-emitting substrate, a color filter layer and a lens layer. The light-emitting substrate is configured to emit initial light. The color filter layer is disposed on the light-emitting substrate, and the color filter layer is configured to filter the initial light into a plurality of kinds of monochromatic light of different colors. The lens layer is disposed on a side of the color filter layer away from the light-emitting substrate. The lens layer is configured to amplify brightness of the plurality of kinds of monochromatic light and to compensate for brightness differences between the plurality of kinds of monochromatic light. The lens layer outputs a plurality of kinds of amplified light of different colors, and brightness differences between the plurality of kinds of amplified light are less than a preset difference.

In some exemplary embodiments, the lens layer includes a plurality of lenses arranged at intervals in a direction parallel to the light-emitting substrate. The plurality of lenses includes at least one first lens and at least one second lens. The first lens and the second lens are configured to transmit monochromatic light of different colors. A brightness amplification gain of the first lens is greater than a brightness amplification gain of the second lens.

In some exemplary embodiments, the plurality of lenses further include at least one third lens. Monochromatic light transmitted by the third lens is configured to have a different color from the monochromatic light transmitted by the first lens and the second lens. The brightness amplification gain of the first lens is larger than a brightness amplification gain of the third lens. Alternatively, the brightness amplification gain of the third lens is configured to be smaller than the brightness amplification gain of the second lens.

In some exemplary embodiments, an end surface of the first lens away from the light-emitting substrate is a first curved surface, and an end surface of the second lens away from the light-emitting substrate is a second curved surface. A curvature of the first curved surface is greater than a curvature of the second curved surface. Alternatively, a maximum dimension of the first lens in a direction perpendicular to the light-emitting substrate is configured to be larger than a maximum dimension of the second lens in the direction perpendicular to the light-emitting substrate. Alternatively, a maximum dimension of the first lens in a direction parallel to the light-emitting substrate is configured to be larger than a maximum dimension of the second lens in the direction parallel to the light-emitting substrate.

In some exemplary embodiments, the color filter layer includes a first color film layer configured to filter the initial light into a first monochromatic light, a second color film layer configured to filter the initial light into a second monochromatic light, and a third color film layer configured to filter the initial light into a third monochromatic light. An orthographic projection of the first lens on a base substrate is within an orthographic projection of the first color film layer on the base substrate. An orthographic projection of the second lens on the base substrate is within an orthographic projection of the second color film layer on the base substrate. An orthographic projection of the third lens on the base substrate is within an orthographic projection of the third color film layer on the base substrate.

In some exemplary embodiments, a minimum distance between the first lens and the second lens in the direction parallel to the light-emitting substrate is configured to be equal to a minimum distance between the first lens layer and the third lens in the direction parallel to the light-emitting substrate.

In some exemplary embodiments, a filling layer is further included, and the filling layer is located between the lens layer and the color filter layer.

In some exemplary embodiments, the filling layer is configured to compensate for a height difference between the first color film layer, the second color film layer, and the third color film layer. Ends of the plurality of lenses close to the light-emitting substrate is located in a same plane parallel to the light-emitting substrate. Alternatively, the filling layer is configured to compensate for a height difference between the first lens, the second lens, and the third lens. Ends of the first lens, the second lens, and the third lens away from the light-emitting substrate are located in a same plane parallel to the light-emitting substrate.

In some exemplary embodiments, a refractive index of the filling layer is configured to be greater than a refractive index of the lens layer and less than a refractive index of the color filter layer.

In some exemplary embodiments, the filling layer is provided with a third curved surface recessed toward the light-emitting substrate. An orthographic projection of at least one of the lenses on the base substrate is configured to overlap with an orthographic projection of the third curved surface on the base substrate. The third curved surface is configured to gather monochromatic light transmitted through the filling layer toward the lens.

In some exemplary embodiments, a plurality of third curved surfaces are provided. The plurality of third curved surfaces are arranged in a direction parallel to the base substrate. The plurality of third curved surfaces are provided as a plurality of curved surfaces having different curvatures.

In some exemplary embodiments, at least one of the first color film layer, the second color film layer, and the third color film layer is provided with a fourth curved surface recessed toward the light-emitting substrate at an end surface away from the light-emitting substrate. The filling layer covers the fourth curved surface, and an orthographic projection of the fourth curved surface on the base substrate is configured to overlap with the orthographic projection of the third curved surface on the base substrate.

In some exemplary embodiments, one of the lenses is configured to cover the third curved surface, and is provided with a fifth curved surface matching the third curved surface at an end surface close to the light-emitting substrate.

In some exemplary embodiments, the fourth curved surface is disposed on the first color film layer. An end of the fourth curved surface close to the light-emitting substrate is configured to flush with ends of the second color film layer and the third color film layer away from the light-emitting substrate. A maximum dimension of a circumferential margin of the first color film layer in the direction perpendicular to the base substrate is a first thickness. The first thickness is configured to be larger than thicknesses of the second color film layer and the third color film layer.

Solutions of the embodiment will be illustrated below through a plurality of examples.

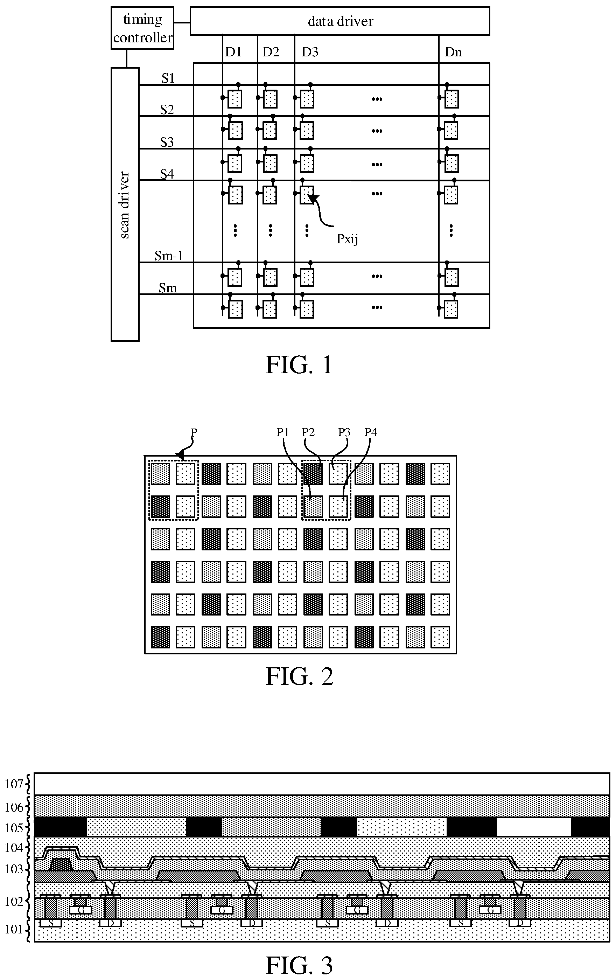

FIG. 1 is a schematic diagram of a structure of a display device. As shown in FIG. 1, an OLED display device may include a timing controller, a data driver, a scan driver and a pixel array. The timing controller is connected with the data driver and the scan driver respectively, the data driver is connected with a plurality of data signal lines (D1 to Dn) respectively, and the scan driver is connected with a plurality of scan signal lines (S1 to Sm) respectively. The pixel array may include a plurality of sub-pixels Pxij. Each sub-pixel Pxij may be connected to a corresponding data signal line and a corresponding scan signal line, wherein i and j may be natural numbers. At least one sub-pixel Pxij may include at least a circuit unit and a display unit. The circuit unit may include at least a pixel driving circuit connected with a scan signal line and a data signal line, respectively. The display unit may include at least a light-emitting device connected with the pixel driving circuit of the circuit unit, and the sub-pixel PXij may refer to a sub-pixel in which a pixel driving circuit is connected with an i-th scan signal line and a j-th data signal line. In an exemplary implementation, the timing controller may provide control signals and grayscale values suitable for the specification of the data driver to the data driver, and may provide a scan start signal, a clock signal or the like suitable for the specification of the scan driver to the scan driver. The data driver may generate data voltages to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate scan signals to be provided to the scan signal lines S1, S2, S3, ..., and Sm by receiving the clock signal and the scan start signal and the like from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting scan start signals provided in a form of an on-level pulse to a next-stage circuit under control of the clock signal, wherein m may be a natural number. In an exemplary implementation, the pixel array may be arranged on a display substrate.

FIG. 2 is a schematic diagram of a planar structure of a display device. As shown in FIG. 2, the display device may include a plurality of pixel units P arranged in a matrix, and at least one of the plurality of pixel units P includes a first sub-pixel P1 emitting light of a first color, a second sub-pixel P2 emitting light of a second color, a third sub-pixel P3 emitting light of a third color, and a fourth sub-pixel P4 emitting light of a fourth color. The four sub-pixels each include a pixel driving circuit and a light-emitting device, and the pixel driving circuit in the sub-pixel is connected to a scan signal line and a data signal line, respectively. The pixel driving circuit is configured to receive a data voltage transmitted by the data signal line and output a corresponding current to a light-emitting device for display under control of the scan signal line. The light-emitting device for display in the sub-pixel is connected to the pixel driving circuit of the sub-pixel where the light-emitting device for display is located, and the light-emitting device for display is configured to emit light with a corresponding brightness in response to the current outputted by the pixel driving circuit of the sub-pixel where the light-emitting device for display is located.

In an exemplary implementation, the first sub-pixel P1 may be a red sub-pixel emitting red (R) light, the second sub-pixel P2 may be a blue sub-pixel emitting blue (B) light, the third sub-pixel P3 may be a green sub-pixel emitting green (G) light, and the fourth sub-pixel P4 may be a white sub-pixel emitting white (W) light. In an exemplary implementation, a shape of the sub-pixels may be any one or more of a triangle, a square, a rectangle, a rhombus, a trapezoid, a parallelogram, a pentagon, a hexagon, and another polygon, and the sub-pixels may be arranged horizontally side by side, vertically side by side, in a shape of an square, or in a diamond shape, etc., which is not limited in the present disclosure.

In an exemplary implementation, the pixel unit may include three sub-pixels, which is not limited in the present disclosure.

FIG. 3 is a schematic diagram of a cross-sectional structure of a display device, illustrating a structure in which full color is realized by using a white light and color film. As shown in FIG. 3, the display device may include a base substrate 101, a drive circuit layer 102 disposed on the base substrate 101, a light-emitting structure layer 103 disposed on a side of the drive circuit layer 102 away from the base substrate 101, a first encapsulation layer 104 disposed on a side of the light-emitting structure layer 103 away from the base substrate 101, a color filter layer 105 disposed on a side of the first encapsulation layer 104 away from the base substrate 101, a second encapsulation layer 106 disposed on a side of the color filter layer 105 away from the base substrate 101, and a cover plate layer 107 disposed on a side of the second encapsulation layer 106 away from the base substrate 101. In some possible implementations, the display device may include other film layers, and the present disclosure is not limited thereto.

In an exemplary implementation, the base substrate 101 may be a bulk silicon base substrate or a silicon-on-insulator (SOI) base substrate. The drive circuit layer 102 may be fabricated on the base substrate 101 through a silicon semiconductor process (e.g., a CMOS process). The drive circuit layer 102 may include a plurality of circuit units, and a circuit unit of the plurality of circuit units may at least include a pixel driving circuit connected to a scan signal line and a data signal line, respectively. The pixel driving circuit may include a plurality of transistors and a storage capacitor. One transistor is shown only in FIG. 3 as an example. The transistor may include a gate electrode G, a first pole S, and a second pole D. The gate electrode G, the first pole S, and the second pole D may respectively be connected to corresponding connection electrodes through vias filled with tungsten metal (i.e., tungsten vias (W-vias)), and may be connected to other electrical structures (e.g., wires) through the connection electrodes.

In an exemplary implementation, the light-emitting structure layer 103 may include a plurality of light-emitting devices, and a light-emitting device of the plurality of light-emitting devices may at least include an anode, an organic light-emitting layer, and a cathode. The anode may be connected to the second pole D of the transistor through a connection electrode, the organic light-emitting layer is connected to the anode, the cathode is connected to the organic light-emitting layer, and the cathode is connected to a second power supply line. The organic light-emitting layer emits light under drive of the anode and the cathode. In an exemplary implementation, the organic light-emitting layer may include an emitting layer (EML) and any one or more of following: a hole injection layer (HIL), a hole transport layer (HTL), an electron blocking layer (EBL), a hole blocking layer (HBL), an electron transport layer (ETL), and an electron injection layer (EIL). In an exemplary implementation, for a light-emitting device emitting white light, organic light-emitting layers of all sub-pixels may be connected together to form a common layer.

In an exemplary implementation, the first encapsulation layer 104 and the second encapsulation layer 106 may be encapsulated in a manner of Thin Film Encapsulation (TFE), so as to ensure that external water vapor cannot enter the light-emitting structure layer. The cover plate layer 107 may be made of glass, or plastic colorless polyimide having flexible characteristics, etc.

In an exemplary implementation, the color filter layer 105 may include a black matrix (BM) and color filters (CF). The color filters are provided in red sub-pixels, green sub-pixels and blue sub-pixels respectively, and filter white light emitted by the light-emitting devices into red (R) light, green (G) light and blue (B) light. The black matrix may be located between adjacent color filters.

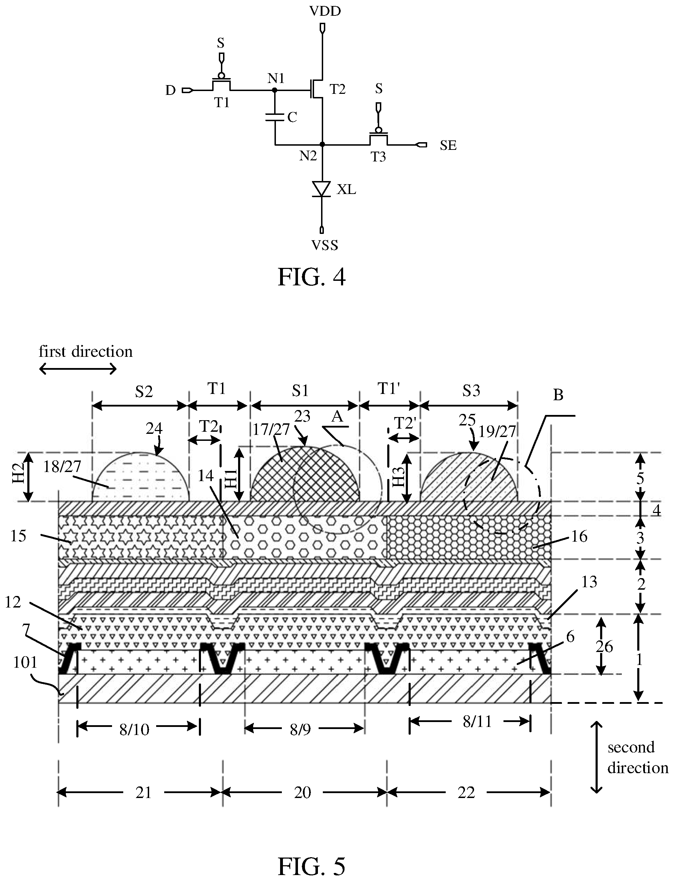

FIG. 4 is an equivalent circuit diagram of a pixel driving circuit. In an exemplary implementation, the pixel driving circuit may be of a structure such as 3T1C, 4T1C, 4T2C, 5T1C, 5T2C, 6T1C, 7T1C, 9T2C or 9T1C. As shown in FIG. 4, the pixel driving circuit may have a 3T1C structure including three transistors (first transistor T1 to third transistor T3) and one storage capacitor C. The pixel driving circuit is connected to four signal lines (scan signal line S, data signal line D, compensation signal line SE, and first power supply line VDD), the first transistor T1 is a switching transistor, the second transistor T2 is a drive transistor, and the third transistor T3 is a compensation transistor.

In an exemplary implementation, each pixel driving circuit may include a first node N1 and a second node N2. The first node N1 is connected with a second pole of the first transistor T1, a gate electrode of the second transistor T2, and a first terminal of the storage capacitor C, respectively, and the second node N2 is connected with a second pole of the second transistor T2, a second pole of the third transistor T3, and a second terminal of the storage capacitor C, respectively.

In an exemplary implementation, the first terminal of the storage capacitor C is connected with the first node N1, the second terminal of the storage capacitor C is connected with the second node N2, and the storage capacitor C is configured to store a potential of the gate electrode of the second transistor T2.

In an exemplary implementation, a gate electrode of the first transistor T1 is connected to the scan signal line S, a first pole of the first transistor T1 is connected to the data signal line D, and the second pole of the first transistor T1 is connected to the first node N1.

In an exemplary implementation, the gate electrode of the second transistor T2 is connected to the first node N1, a first pole of the second transistor T2 is connected to the first power supply line VDD, and the second pole of the second transistor T2 is connected to the second node N2.

In an exemplary implementation, a gate electrode of the third transistor T3 is connected to the scan signal line S, a first pole of the third transistor T3 is connected to the compensation signal line SE, and a second pole of the third transistor T3 is connected to the second node N2.

In an exemplary implementation, a first pole of a light-emitting device XL is connected to the second node N2, and a second pole of the light-emitting device XL is connected to the second power supply line VSS.

In an exemplary implementation, the light-emitting device XL may be an organic electroluminescent diode (OLED), including a first pole (e.g. anode), an organic light-emitting layer and a second pole (e.g. cathode) that are stacked.

In an exemplary implementation, the first transistor T1 is configured to receive a data voltage transmitted by the data signal line D under the control of a signal of the scan signal line S, store the data voltage to the storage capacitor C, and supply the data voltage to the gate electrode of the second transistor T2. The second transistor T2 is configured to generate a corresponding current at the second pole under the control of a data signal received by the gate electrode thereof. The second transistor T2 is configured to supply a signal of the first power supply line VDD to the second node N2 under the control of the third transistor T3 to drive the light-emitting device for display XL to emit light. The third transistor T3 is configured to extract a threshold voltage Vth and a mobility of the second transistor T2 in response to compensation timing to compensate the threshold voltage Vth. The storage capacitor C is configured to store a potential of the gate electrode of the second transistor T2. The light-emitting device XL is configured to emit light with a corresponding brightness in response to the current of the second pole of the second transistor T2.

In an exemplary implementation, the signal of the first power supply line VDD may be a high-level signal continuously provided, and a signal of the second power supply line VSS may be a low-level signal continuously provided.

In an exemplary implementation, the first transistor T1, the second transistor T2 and the third transistor T3 may be P-type transistors. In another exemplary implementation, the first transistor T1, the second transistor T2, and the third transistor T3 may be N-type transistors. Using a same type of transistors in the pixel driving circuit may simplify a process flow, reduce a process difficulty of a display panel, and improve a product yield. In yet another exemplary implementation, the first transistor T1, the second transistor T2 and the third transistor T3 may include a P-type transistor and an N-type transistor. For example, the first transistor T1 and the third transistor T3 may be a P-type metal oxide semiconductor transistor (PMOS), and the second transistor T2 may be an N-type metal oxide semiconductor transistor (NMOS).

In an exemplary implementation, for the first transistor T1 to the third transistor T3, low temperature poly-silicon thin film transistors may be used, oxide thin film transistors may be used, or a low temperature poly-silicon thin film transistor and an oxide thin film transistor may be used. An active layer of the low temperature poly-silicon thin film transistor is made of Low Temperature Poly-Silicon (LTPS), and an active layer of the oxide thin film transistor is made of an oxide semiconductor (Oxide). The low temperature poly-silicon thin film transistor has advantages, such as a high mobility and fast charging, and the oxide thin film transistor has advantages, such as a low leakage current. The low temperature poly-silicon thin film transistor and the oxide thin film transistor are integrated on one display substrate, that is, an LTPS+Oxide (LTPO) display substrate, so that advantages of the low temperature poly-silicon thin film transistor and the oxide thin film transistor may be utilized, low-frequency drive may be achieved, power consumption may be reduced, and a display quality may be improved.

Silicon-based OLED micro-display devices use integrated circuits to control OLED, which can increase a resolution (usually reaching more than 3000 ppi), but brings great challenges to preparation of OLED display devices. For example, the traditional fine metal mask (FMM) can achieve up to about 800 PPI, which means that it is difficult for the silicon-based OLED display devices to use side by side (SBS) monochrome devices for OLED evaporation, and other means need to be used to separate OLED pixels. These separation means include, but are not limited to, tall separation post (Tall Fence, TF), dig between pixel (Dig on wafer, DOW), and the like. These means can only separate the light-emitting device at the anode, and cannot be realized at the time of evaporation.

The silicon-based OLED micro-display devices can only use white light devices. In order to improve the efficiency, brightness and life of the silicon-based OLED micro-display devices, stacked OLED devices (tandem OLED) with more than two light-emitting units can be used. By employing a so-called charge generation layer (CGL) to connect upper and lower light-emitting units in series, a superimposed light-emitting effect on the device is achieved, successfully improving important photoelectric performance indicators such as current efficiency, output brightness and operating life. The white light device can be combined with tricolor color glue to achieve full-color display, and the lens plays a role in gathering light, amplifying the brightness of the light. The applicant found that at present, a transmittance of color glue is only about 20%, especially a transmittance of blue color glue is often less than 20%, and the shape and size of the lens are the same. This makes the brightness of the output blue light slightly lower than that of other color light. In order to solve this problem, the silicon-based OLED micro-display devices usually give different current densities to pixels of different colors for improving the efficiency of blue light, so as to ensure that color point of the final synthesized white light is about (0.31, 0.33). Accordingly, blue light with relatively weak brightness needs to be given more current, which increases the load of the light-emitting unit of blue light during use, and causes the life of the light-emitting unit of blue light to be smaller than that of the light-emitting unit of red light and the light-emitting unit of green light. This not only affects the life of the display device, but also causes an increase in the proportions of red light and green light during use, causing the picture to gradually turn yellow, and thus affecting the display effect.

FIG. 5 is a schematic cross-sectional view of a display panel of the present exemplary embodiment. The embodiment provides a display panel. As shown in FIG. 5, the display panel may include a light-emitting substrate 1, a color filter layer 3, and a lens layer 5. The light-emitting substrate 1 may include a base substrate 101 and a light-emitting structure 26. The light-emitting structure 26 may emit initial light. The color filter layer 3 may be provided on the light-emitting substrate 1, and the color filter layer 3 may filter the initial light into a plurality of kinds of monochromatic light of different colors. The lens layer 5 may be disposed on a side of the color filter layer 3 away from the light-emitting substrate 1. The lens layer 5 may amplify brightness of a plurality of kinds of monochromatic light and compensate for brightness differences between the plurality of kinds of monochromatic light. The lens layer 5 outputs a plurality of kinds of amplified light of different colors, and brightness differences between the plurality of kinds of amplified light are less than a preset difference. Accordingly, in the display panel of the present example, the lens layer 5 compensates for the brightness difference, making the light of different colors more balanced. Additionally it makes the current distribution among the respective light-emitting units more balanced, reduces the load of a single light-emitting unit, increases the life, reduces the color cast when the product is used, and improves the uniformity of the product.

In some exemplary embodiments, as shown in FIG. 5, the light-emitting substrate 1 may include a base substrate 101 and a light-emitting structure 26 disposed on the base substrate 101. A second direction is perpendicular to the base substrate 101, and the second direction is also perpendicular to the light-emitting substrate. The light-emitting structure 26 is located on one side of the base substrate 101 in the second direction, and the light-emitting structure 26 includes a plurality of light-emitting elements and a pixel definition layer 7 separating the light-emitting elements. The light-emitting element may include a first electrode 6, an organic light-emitting layer 12, and a second electrode 13 that are stacked. The pixel definition layer 7 is disposed on the first electrode 6. The pixel definition layer 7 may be provided with a plurality of pixel openings 8, and one pixel opening 8 may expose at least a part of a surface of one corresponding first electrode 6. At least a portion of the organic light-emitting layer 12 may be disposed within one pixel opening 8 and connected with a corresponding first electrode 6. The second electrode 13 may be disposed on the organic light-emitting layer 12 and be connected with the organic light-emitting layer 12. The organic light-emitting layer 12 may emit light of a corresponding color under drive of the first electrode 6 and the second electrode 13. The organic light-emitting layers 12 of the respective light-emitting elements extend continuously in a first direction and are arranged in a same layer. The first direction is perpendicular to the second direction and parallel to the base substrate 101. The organic light-emitting layer 12 may have two or more light-emitting units that are stacked. The charge generation layer may connect upper and lower light-emitting units adjacent to each other in series. The light emitted by the organic light-emitting layer 12 is a white initial light. The initial light is irradiated away from the base substrate 101 in the second direction.

In some exemplary embodiments, as shown in FIG. 5, the display panel further includes an encapsulation layer 2, which may be located on a side of the light-emitting structure 26 away from the base substrate 101. The encapsulation layer 2 may be a multilayer structure stacked and arranged in the second direction. The encapsulation layer 2 adopts an inorganic material, an organic material, or a mixed structure of organic and inorganic materials. The encapsulation layer 2 can ensure that external water vapor cannot enter the light-emitting element.

In some exemplary embodiments, as shown in FIG. 5, the color filter layer 3 may include a first color film layer 14 configured to filter the white light into a first monochromatic light, a second color film layer 15 configured to filter the white light into a second monochromatic light, and a third color film layer 16 configured to filter the white light into a third monochromatic light. The colors of the first monochromatic light, the second monochromatic light, and the third monochromatic light are different, and the first monochromatic light may be blue light, the second monochromatic light may be red light, and the third monochromatic light may be green light, but it is not limited thereto. For example, the first monochromatic light may be blue light, the second monochromatic light may be green light, and the third monochromatic light may be red light. For another example, the first monochromatic light may be red light, the second monochromatic light may be blue light, and the third monochromatic light may be green light. For another example, the first monochromatic light may be red light, the second monochromatic light may be green light, and the third monochromatic light may be blue light. For another example, the first monochromatic light may be green light, the second monochromatic light may be red light, and the third monochromatic light may be blue light. For another example, the first monochromatic light may be green light, the second monochromatic light may be blue light, and the third monochromatic light may be red light.

In some exemplary embodiments, as shown in FIG. 5, the first color film layer 14, the second color film layer 15, and the third color film layer 16 are arranged in an array in a plane parallel to the base substrate 101. The first color film layer 14, the second color film layer 15, and the third color film layer 16 are respectively arranged corresponding to different pixel openings 8 in the first direction. The plurality of pixel openings 8 may include a first opening 9, a second opening 10 and a third opening 11. An orthographic projection of the first opening 9 on the base substrate 101 may be within an orthographic projection of the first color film layer 14 on the base substrate 101. An orthographic projection of the second opening 10 on the base substrate 101 may be within an orthographic projection of the second color film layer 15 on the base substrate 101. An orthographic projection of the third opening 11 on the base substrate 101 may be within an orthographic projection of the third color film layer 16 on the base substrate 101. A light-emitting element located in the first opening 9 may be a first light-emitting element 20. A light-emitting element located in the second opening 10 may be a second light-emitting element 21. A light-emitting element located in the third opening 11 may be a third light-emitting element 22. As a result, the first light-emitting element 20, the second light-emitting element 21, and the third light-emitting element 22 all emit white initial light. The initial light emitted by the first light-emitting element 20 is filtered into first monochromatic light after passing through the first color film layer 14. The initial light emitted by the second light-emitting element 21 is filtered into second monochromatic light after passing through the second color film layer 15. The initial light emitted by the third light-emitting element 22 is filtered into first monochromatic light after passing through the third color film layer 16.

In some exemplary embodiments, as shown in FIG. 5, the display panel further includes a filling layer 4, which may be located between the lens layer 5 and the color filter layer 3, and the filling layer 4 covers a surface of the color filter layer 3 close to the lens layer 5. The filling layer 4 can adjust positions of respective lenses 27 in the second direction. The second direction is perpendicular to the base substrate 101. In some exemplary embodiments, the filling layer 4 may compensate for height differences between the first color film layer 14, the second color film layer 15, and the third color film layer 16. Ends of the plurality of lenses 27 close to the light-emitting substrate 1 are located in a same plane parallel to the light-emitting substrate. For example, heights of the first color film layer 14, the second color film layer 15, and the third color film layer 16 are different so that end surfaces of the first color film layer 14, the second color film layer 15, and the third color film layer 16 away from the light-emitting substrate 1 are not flush. The filling layer 4 may smooth out the height differences, a surface of the filling layer 4 away from the base substrate 101 may be a plane parallel to the base substrate 101, and the plurality of lenses 27 are located in a same plane. But it is not limited thereto, and the filling layer 4 may compensate for height differences between the first lens 17, the second lens 18, and the third lens 19. For example, ends of the first lens 17, the second lens 18, and the third lens 19 away from the light-emitting substrate 1 are located in a same plane parallel to the light-emitting substrate 1. Regardless of whether the first color film layer 14, the second color film layer 15, and the third color film layer 16 are the same, and regardless of whether the heights of the first lens 17, the second lens 18, and the third lens 19 are different, the ends of the first lens 17, the second lens 18, and the third lens 19 away from the light-emitting substrate 1 may be located in a same plane by adjusting the thickness of the filling layer 4. In some exemplary embodiments, the filling layer 4 is located between the lens layer 5 and the color filter layer 3, and can adjust positions of the respective lenses 27 in the second direction.

In some exemplary embodiments, as shown in FIG. 5, the lens layer 5 includes a plurality of lenses 27 arranged in an array and arranged at intervals in a plane parallel to the base substrate 101. The plurality of lenses 27 may include at least one first lens 17, at least one second lens 18, and at least one third lens 19. The first lens 17, the second lens 18, and the third lens 19 are configured to transmit monochromatic light of different colors. A brightness amplification gain of the first lens 17, a brightness amplification gain of the second lens 18 and a brightness amplification gain of the third lens 19 may be different. The brightness amplification gain refers to an increase data of brightness of output light relative to brightness of input light. End surfaces of the plurality of lenses 27 close to the light-emitting substrate 1 may be flush, that is, distances between ends of the plurality of lenses 27 close to the light-emitting substrate 1 and the light-emitting substrate 1 are equal. The filling layer 4 compensates for the height differences between the first color film layer 14, the second color film layer 15, and the third color film layer 16, but it is not limited thereto. For example, the distances between the ends of the plurality of lenses 27 close to the light-emitting substrate 1 and the light-emitting substrate 1 are not equal. The lens 27 and the pixel opening 8 are in one-to-one correspondence. An orthographic projection of the lens 27 on the base substrate 101 is within an orthographic projection of the pixel opening 8 on the base substrate 101. An orthographic projection of a center of the pixel opening 8 on the base substrate 101 overlaps with an orthographic projection of a center of the lens 27 on the base substrate 101. That is, the center of the pixel opening 8 and the center of the lens 27 are collinear in the second direction. An orthographic projection of the first lens 17 on the base substrate 101 is within an orthographic projection of the first color film layer 14 on the base substrate 101 and also within an orthographic projection of the first opening 9 on the base substrate 101. An orthographic projection of the second lens 18 on the base substrate 101 is within an orthographic projection of the second color film layer 15 on the base substrate 101 and also within an orthographic projection of the second opening 10 on the base substrate 101. An orthographic projection of the third lens 19 on the base substrate 101 is within an orthographic projection of the third color film layer 16 on the base substrate 101 and also within an orthographic projection of the third opening 11 on the base substrate 101.

In some exemplary embodiments, as shown in FIG. 5, the first color film layer 14 may be blue glue, and the filtered first monochromatic light may be blue light. The second color film layer 15 may be red glue, and the filtered second monochromatic light may be red light. The third color film layer 16 may be red glue, and the filtered third monochromatic light may be red light. In the case of the same thickness, a transmittance of the blue glue is smaller than a transmittance of the red glue and a transmittance of the green glue. Consequently, after initial light of the same brightness passes through the first color film layer 14, the second color film layer 15 and the third color film layer 16, the brightness of the first monochromatic light is smaller than the brightness of the second monochromatic light and the third monochromatic light, forming a brightness difference, so that the blue light is darker. But it is not limited thereto, for example, the transmittances of the blue glue and the green glue are both smaller than the transmittance of the red glue. As a result, after the initial light of the same brightness passes through the first color film layer 14, the second color film layer 15, and the third color film layer 16, both the brightness of the first monochromatic light and the brightness of the third monochromatic light are smaller than the brightness of the second monochromatic light, thereby also forming a brightness difference.

In some exemplary embodiments, as shown in FIG. 5, when the brightness of the first monochromatic light is smaller than that of the second monochromatic light and the third monochromatic light, differences between the first lens 17, the second lens 18, and the third lens 19 can make up for the brightness differences, so that the brightness of the output light is substantially the same. That is, the brightness of first amplified light (blue light) output by the first lens 17, the brightness of second amplified light (red light) output by the second lens 18, and the brightness of third amplified light (green light) output by the third lens 19 tend to be the same, and a preset difference between any two data may be zero. The differences between the first lens 17, the second lens 18, and the third lens 19 may be configured so that the brightness amplification gain of the first lens 17 is greater than the brightness amplification gain of the second lens 18, and is greater than the brightness amplification gain of the third lens 19. In some exemplary embodiments, the brightness amplification gain of the second lens 18 is equal to the brightness amplification gain of the third lens 19.

In some exemplary embodiments, as shown in FIG. 5, an end surface of each lens 27 away from the base substrate 101 may be a curved surface protruding in a direction away from the base substrate 101, such that a side the lens 27 away from the base substrate 101 forms a convex lens structure. An end surface of the first lens 17 away from the base substrate 101 may be a first curved surface 23, an end surface of the second lens 18 away from the base substrate 101 may be a second curved surface 24, and an end surface of the third lens 19 away from the base substrate 101 may be a sixth curved surface 25. A size of the lens 27, as well as curvature of the curved surface of the lens 27 away from the base substrate 101, may affect the lens 27. For example, the larger the size of the lens 27, the larger the brightness amplification gain of the lens 27. For another example, in a case where the size of the lenses 27 is the same, the greater the curvature of the curved surface of the lenses 27 away from the base substrate 101, the larger the brightness amplification gain of the lenses 27.

In some exemplary embodiments, as shown in FIG. 5, a height of the lens 27 may be a maximum dimension of the lens 27 in the second direction, and a width of the lens 27 may be a maximum dimension of the lens 27 in the direction parallel to the base substrate 101 (i.e., the first direction). The height of the lenses 27 may be from 1 micron to 3 microns, the width of the lenses 27 may be from 2 microns to 9 microns, and a spacing between adjacent lenses 27 may be from 0.3 microns to 1.5 microns.

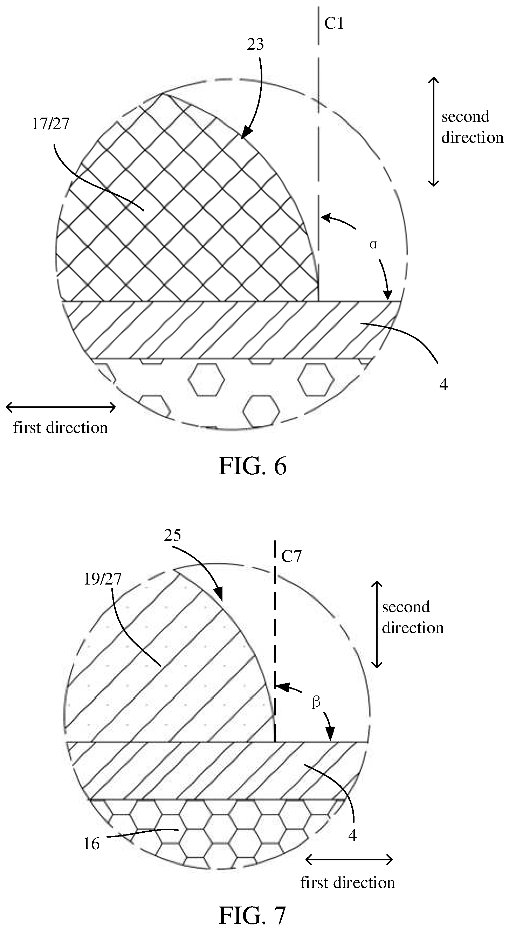

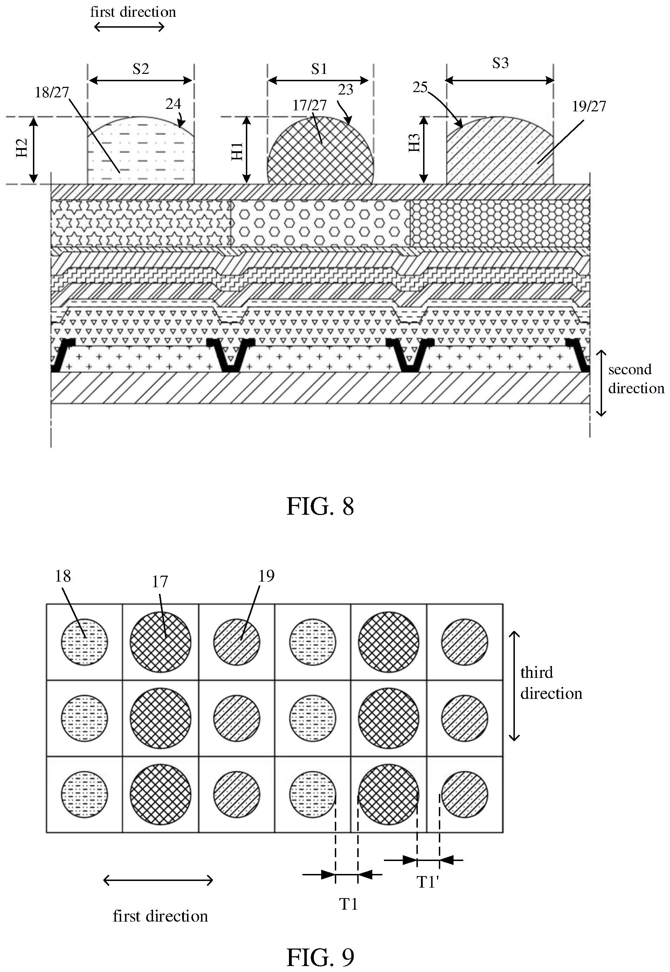

FIG. 6 is a partially enlarged schematic view at A in FIG. 5, and FIG. 7 is a partially enlarged schematic view at B in FIG. 5. In some exemplary embodiments, as shown in FIGS. 5 and 6, the first curved surface 23, the second curved surface 24, and the sixth curved surface 25 all extend toward the base substrate 101 and extend to the filling layer 4, such that the first lens 17, the second lens 18, and the third lens 19 are all incomplete spherical shapes. A tangent line of the first curved surface 23 at a point where a cross-section of the first curved surface 23 in a plane perpendicular to the base substrate 101 is close to the filling layer 4 is a first tangent line (C1). An angle between the first tangent line (C1) and a surface on which the lens is located (that is, a surface of the filling layer 4 away from the base substrate 101) may be α, which may be 90°. The first tangent line (C1) is in the same direction as the second direction, that is, perpendicular to the base substrate 101, so that a viewing angle of the first lens 17 varies greatly, but it is not limited thereto, for example, 30° < α < 120°. In some exemplary embodiments, as shown in FIGS. 5 and 8, a tangent line of the sixth curved surface 25 at a point where a cross-section of the sixth curved surface 25 in the plane perpendicular to the base substrate 101 is close to the filling layer 4 is a second tangent line (C7). An angle between the second tangent line (C7) and a surface on which the lens is located may be β, which may be less than α, but it is not limited thereto, and may be equal to α or greater than α.

In some exemplary embodiments, as shown in FIG. 5, a height (H1) of the first lens 17 may be a maximum dimension of the first lens 17 in the second direction, a height (H2) of the second lens 18 may be a maximum dimension of the second lens 18 in the second direction, and a height (H3) of the third lens 19 may be a maximum dimension of the third lens 19 in the second direction. The height (H1) of the first lens 17 may be greater than the height (H2) of the second lens 18, and the height (H2) of the second lens 18 is equal to the height (H3) of the third lens 19, such that a size of the first lens 17 is greater than sizes of the second lens 18 and the third lens 19. The sizes of the second lens 18 and the third lens 19 are consistent, and the brightness amplification gain of the first lens 17 is greater than the brightness amplification gains of the second lens 18 and the third lens 19.

In some exemplary embodiments, as shown in FIG. 5, a width (first width S1) of the first lens 17 may be a maximum dimension of the first lens 17 in the first direction, a width (second width S2) of the second lens 18 may be a maximum dimension of the second lens 18 in the first direction, and a width (third width S3) of the third lens 19 may be a maximum dimension of the third lens 19 in the first direction. The first width S1 may be larger than the second width S2, and the second width S2 is equal to the third width S3, such that a size of the first lens 17 is greater than sizes of the second lens 18 and the third lens 19. The sizes of the second lens 18 and the third lens 19 are consistent, and the brightness amplification gain of the first lens 17 is greater than the brightness amplification gains of the second lens 18 and the third lens 19.

FIG. 8 is a schematic cross-sectional view of another display panel of the present exemplary embodiment. In some exemplary embodiments, as shown in FIG. 8, the first lens 17, the second lens 18, and the third lens 19 are not spherical, and only have curved surfaces, namely, the first curved surface 23, the second curved surface 24, and the sixth curved surface 25, respectively, at end surfaces away from the base substrate 101. The height (H1) of the first lens 17 is equal to the height (H2) of the second lens 18, the height (H2) of the second lens 18 is equal to the height (H3) of the third lens 19, and the first width S1 may be equal to the second width S2 and the third width S3, so that the heights and widths of the three lenses 27 are consistent. The curvature of the first curved surface 23 is greater than the curvature of the second curved surface 24 and the curvature of the sixth curved surface 25, and the curvature of the second curved surface 24 is equal to the curvature of the sixth curved surface 25, so that the brightness amplification gain of the first lens 17 is greater than the brightness amplification gains of the second lens 18 and the third lens 19.

In some exemplary embodiments, as shown in FIG. 5, in a case where the brightness of the first monochromatic light is smaller than the brightness of the second monochromatic light and the third monochromatic light, the first lens 17 amplifies the brightness of the first monochromatic light and adjusts the brightness of the first amplified light (blue light) to be equal to the brightness of the second amplified light (red light) output by the second lens 18 and the brightness of the third amplified light (green light) output by the third lens 19. This compensates for the brightness differences among the plurality of kinds of monochromatic light.

FIG. 9 is a top view of the display panel in FIG. 5. In some exemplary embodiments, as shown in FIGS. 5 and 9, the first lens 17, the second lens 18, and the third lens 19 are arranged in a matrix in a plane constituted by a first direction and a third direction. A row direction of the matrix coincides with the first direction, a column direction of the matrix coincides with the third direction, and the third direction is perpendicular to the first direction and perpendicular to the second direction. The second lens 18 and the third lens 19 are respectively located on two sides of the first lens 17 in the first direction. A distance between the first lens 17 and the second lens 18 is a first spacing (T1), and a distance between the first lens 17 and the third lens 19 is a second spacing (T1'). The first spacing (T1) may be a minimum distance between the first lens 17 and the second lens 18 in the direction parallel to the light-emitting substrate 1 (i.e. the first direction). The second spacing (T1') may be a minimum distance between the first lens 17 layer 4 and the third lens 19 in the direction parallel to the light-emitting substrate 1 (i.e. the first direction). The first spacing (T1) may be equal to the second spacing (T1'), so that distribution of the lenses 27 is uniform, which is beneficial to the uniformity of light emission.

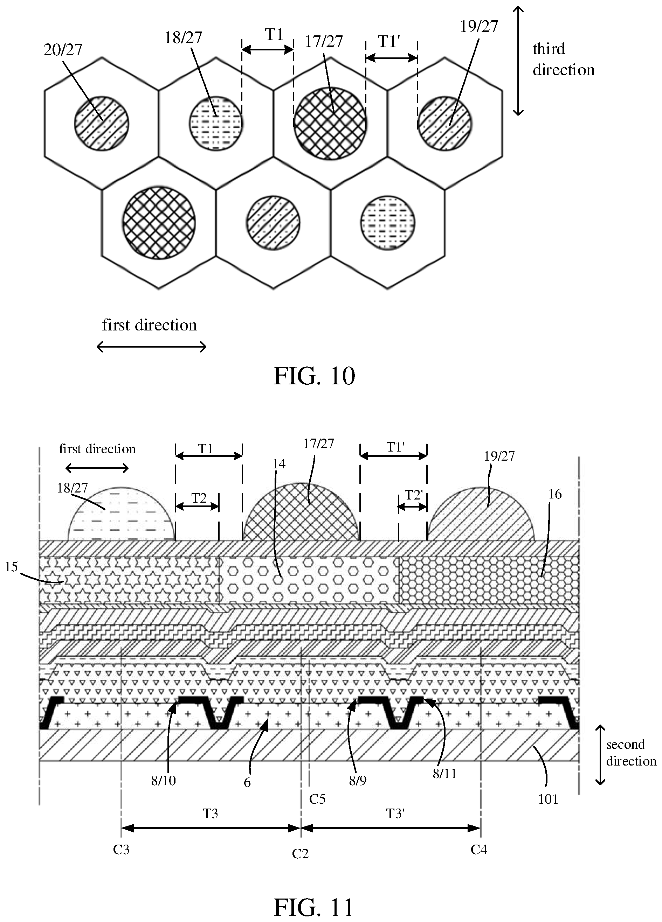

FIG. 10 is a top view of another display panel of the present exemplary embodiment. In some exemplary embodiments, as shown in FIG. 10, the first lens 17, the second lens 18, and the third lens 19 are arranged in an array, and the lenses 27 are staggered in a third direction. One first lens 17, one second lens 18 and one third lens 19 form one lens group, in which the second lens 18 and the third lens 19 are respectively located on two sides of the first lens 17 in a second direction. A plurality of lens groups are arranged in a plane formed by the first direction and the third direction. A distance between the first lens 17 and the second lens 18 is a first spacing (T1), and a distance between the first lens 17 and the third lens 19 is a second spacing (T1'). The first spacing (T1) may be equal to the second spacing (T1'), so that distribution of the lenses 27 is uniform, which is beneficial to the uniformity of light emission.

In some exemplary embodiments, as shown in FIG. 5, spacings between the individual pixel openings 8 in a direction parallel to the base substrate 101 (the first direction) are the same. For example, a distance between the first opening 9 and the second opening 10 is equal to a distance between the first opening 9 and the third opening 11. An orthographic projection of a center of the pixel opening 8 on the base substrate 101 overlaps with an orthographic projection of a center of the first electrode 6 on the base substrate 101. That is, the center of the pixel opening 8 and the center of the first electrode 6 are collinear in the second direction. The orthographic projection of the center of the pixel opening 8 on the base substrate 101 overlaps with an orthographic projection of a center of the lens 27 corresponding to the pixel opening 8 on the base substrate 101. That is, the center of the pixel opening 8 and the center of the lens 27 corresponding to the pixel opening 8 are collinear in the second direction. The orthographic projection of the center of the pixel opening 8 on the base substrate 101 overlaps with an orthographic projection of a center of the color glue corresponding to the pixel opening 8 on the base substrate 101. That is, the center of the pixel opening 8 and the center of the color glue corresponding to the pixel opening 8 are collinear in the second direction. For example, an orthographic projection of a center of the first opening 9 on the base substrate 101 overlaps with an orthographic projection of a center of the first electrode 6 corresponding to the first opening 9 on the base substrate 101. The orthographic projection of the center of the first opening 9 on the base substrate 101 overlaps with an orthographic projection of a center of the first lens 17 on the base substrate 101. The orthographic projection of the center of the first opening 9 on the base substrate 101 overlaps with an orthographic projection of a center of a first color film layer 14 on the base substrate 101. For another example, an orthographic projection of a center of the second opening 10 on the base substrate 101 overlaps with an orthographic projection of a center of the first electrode 6 corresponding to the second opening 10 on the base substrate 101. The orthographic projection of the center of the second opening 10 on the base substrate 101 overlaps with an orthographic projection of a center of the second lens 18 on the base substrate 101. The orthographic projection of the center of the second opening 10 on the base substrate 101 overlaps with an orthographic projection of a center of a second color film layer 15 on the base substrate 101. For another example, an orthographic projection of a center of the third opening 11 on the base substrate 101 overlaps with an orthographic projection of a center of the first electrode 6 corresponding to the third opening 11 on the base substrate 101. The orthographic projection of the center of the third opening 11 on the base substrate 101 overlaps with an orthographic projection of a center of the third lens 19 on the base substrate 101. The orthographic projection of the center of the third opening 11 on the base substrate 101 overlaps with an orthographic projection of a center of a third color film layer 16 on the base substrate 101.

In some exemplary embodiments, as shown in FIG. 5, a minimum distance (T2) between the first color film layer 14 and the second lens 18 in a direction parallel to the light-emitting substrate 1 (first direction) may be equal to a minimum distance (T2') between the first color film layer 14 and the third lens 19 in the direction parallel to the light-emitting substrate 1 (first direction).

FIG. 11 is a schematic cross-sectional view of yet another display panel of the present exemplary embodiment. In some exemplary embodiments, as shown in FIG. 11, spacings between the individual pixel opening 8 in a direction parallel to the base substrate 101 (first direction) are the same. For example, a distance between the first opening 9 and the second opening 10 is equal to a distance between the first opening 9 and the third opening 11. A straight line along the second direction and passing through the center of the first opening 9 is a first straight line C2. A straight line along the second direction and passing through the center of the second opening 10 is a second straight line C3. A straight line along the second direction and passing through the center of the third opening 10 is a third straight line C4. A spacing between the center of the first opening 9 and the center of the second opening 10 in the first direction may be a third spacing (T3). A spacing between the center of the first opening 9 and the center of the third opening 11 in the first direction may be a fourth spacing (T3'). The third spacing (T3) is equal to the fourth spacing (T3'). An orthographic projection of a center of the pixel opening 8 on the base substrate 101 does not overlap with an orthographic projection of a center of the first electrode 6 corresponding to the pixel opening 8 on the base substrate 101. That is, the center of the pixel opening 8 and the center of the first electrode 6 corresponding to the pixel opening 8 are non-collinear in the second direction. For example, a straight line along the second direction and passing through the center of the first electrode 6 corresponding to the first opening 9 is a fourth straight line C5. The first straight line C2 and the fourth straight line C5 are parallel and do not coincide. A minimum distance (T2) between the first color film layer 14 and the second lens 18 in a direction parallel to the light-emitting substrate 1 (first direction) may be less than a minimum distance (T2') between the first color film layer 14 and the third lens 19 in the direction parallel to the light-emitting substrate 1 (first direction). A distance between the first lens 17 and the second lens 18 is a first spacing (T1), and a distance between the first lens 17 and the third lens 19 is a second spacing (T1'). The first spacing (T1) may be equal to the second spacing (T1').

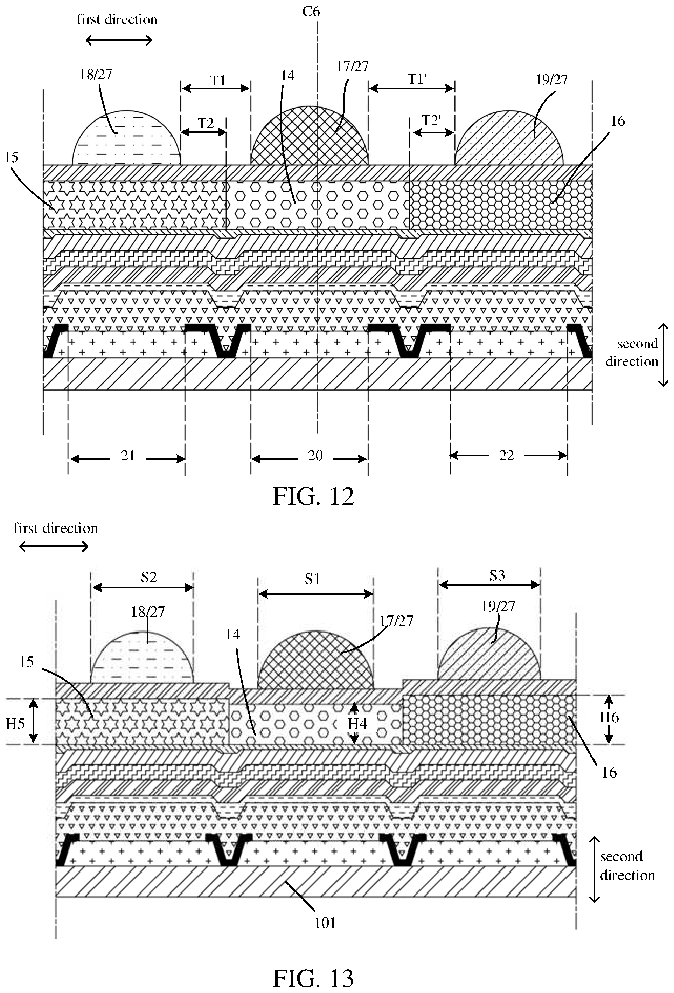

FIG. 12 is a schematic cross-sectional view of another display panel of the present exemplary embodiment. In some exemplary embodiments, as shown in FIG. 12, an orthographic projection of a center of the pixel opening 8 on the base substrate 101 does not overlap with an orthographic projection of a center of the first electrode 6 on the base substrate 101. That is, the center of the pixel opening 8 and the center of the first electrode 6 are non-collinear in the second direction. The second opening 10 and the third opening 11 are respectively located on two sides of the first opening 9 in the first direction. A straight line extending in the second direction and passing through the center of the first color film layer 14 is a fifth straight line C6. The fifth straight line C6 is a center line of the first color film layer 14. The second opening 10 and the third opening 11 are symmetrical about the fifth straight line C6 in the first direction. A minimum distance (T2) between the first color film layer 14 and the second lens 18 in a direction parallel to the light-emitting substrate 1 (first direction) may be equal to a minimum distance (T2') between the first color film layer 14 and the third lens 19 in the direction parallel to the light-emitting substrate 1 (first direction). A distance between the first lens 17 and the second lens 18 is a first spacing (T1), and a distance between the first lens 17 and the third lens 19 is a second spacing (T1'). The first spacing (T1) is not equal to the second spacing (T1').

FIG. 13 is a schematic cross-sectional view of yet another display panel of the present exemplary embodiment. In some exemplary embodiments, as shown in FIG. 13, a thickness (H4) of the first color film layer 14, a thickness (H5) of the second color film layer 15, and a thickness (H6) of the third color film layer 16 may sequentially increase, that is, H4 < H5 < H6. The thickness (H4) of the first color film layer 14 may be a maximum dimension of the first color film layer 14 in a direction perpendicular to the light-emitting substrate 1 (i.e., a second direction). The thickness of the second color film layer 15 is configured to be a maximum dimension of the second color film layer 15 in the direction perpendicular to the light-emitting substrate 1 (i.e., the second direction). The thickness of the third color film layer 16 is configured to be a maximum dimension of the third color film layer 16 in the direction perpendicular to the light-emitting substrate 1 (i.e., the second direction). A thickness difference between the first color film layer 14 and the second color film layer 15 is configured to be less than or equal to 0.8 microns, that is, (H5-H4) ≤ 0. 8 µm. A thickness difference between the second color film layer 15 and the third color film layer 16 is configured to be less than or equal to 0.8 microns, that is, (H6-H5) ≤ 0. 8 µm. Among the thickness (H4) of the first color film layer 14, the thickness (H5) of the second color film layer 15, and the thickness (H6) of the third color film layer 16, the greater the thickness, the smaller the transmittance, such that the third monochromatic light transmitted through the third color film layer 16 has the lowest brightness.

In some exemplary embodiments, as shown in FIG. 13, the widths of the first lens 17, the second lens 18, and the third lens 19 sequentially increase, so that the brightness amplification gain of the first lens 17, the brightness amplification gain of the second lens 18, and the brightness amplification gain of the third lens 19 need to be configured to sequentially increase. The brightness amplification gain of the third lens 19 is relatively large, so that the third lens 19 can compensate for the third monochromatic light having a lower brightness, thereby achieving equivalent brightness of the light of each color. The width of the first lens 17 may be a first width S1, the width of the second lens 18 may be a second width S2, and the width of the third lens 19 may be a third width S3, where S1 < S2 < S3. An outer dimension of the third lens 19 is large, so that the brightness amplification gain of the third lens 19 is relatively large. A difference between the first width S1 and the second width S2 is less than or equal to 1.5 microns, that is, (S2-S1) ≤ 1.5 µm. A difference between the second width S2 and the third width S3 is configured to be less than or equal to 1.5 microns, that is, (S3 - S2) ≤ 1.5 µm.

In some exemplary embodiments, as shown in FIG. 13, end surfaces of the first lens 17, the second lens 18, and the third lens 19 close to the base substrate 101 are not flush due to differences in the thickness (H4) of the first color film layer 14, the thickness (H5) of the second color film layer 15, and the thickness (H6) of the third color film layer 16.

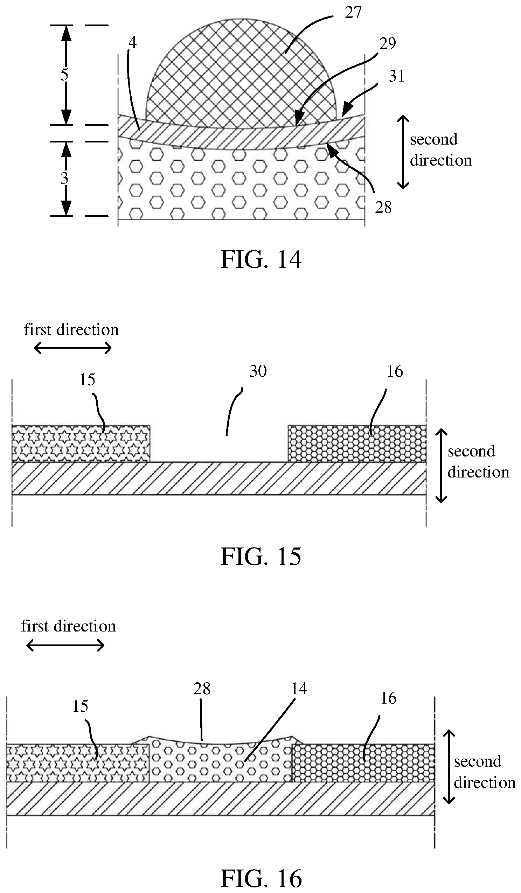

FIG. 14 is a schematic diagram of another lens of the present exemplary embodiment. In some exemplary embodiments, as shown in FIG. 14, a refractive index of a filling layer 4 may be larger than a refractive index of a lens layer 5, and the refractive index of the filling layer 4 may be smaller than a refractive index of a color filter layer 3, so that the refractive indexes of the color filter layer 3, the filling layer 4, and the lens layer 5 decrease sequentially. The filling layer 4 is provided with a third curved surface 31. An orthographic projection of at least one lens 27 on the base substrate can overlap with an orthographic projection of the third curved surface 31 on the base substrate. The third curved surface 31 can gather monochromatic light transmitted through the filling layer toward the lens 27. In some exemplary embodiments, a plurality of third curved surfaces 31 are provided. The plurality of third curved surfaces 31 are arranged in a direction parallel to the base substrate. The plurality of third curved surfaces 31 are provided as a plurality of curved surfaces having different curvatures. In some exemplary embodiments, as shown in FIG. 14, the color filter layer 3 may be provided with a fourth curved surface 28. The filling layer 3 covers the fourth curved surface 28. An orthographic projection of the fourth curved surface 28 on the base substrate is configured to overlap with an orthographic projection of the third curved surface 31 on the base substrate. In some exemplary embodiments, as shown in FIG. 14, the lens 27 may cover part or all of the third curved surface 31 and be provided with a fifth curved surface 29 that matches the third curved surface 31.

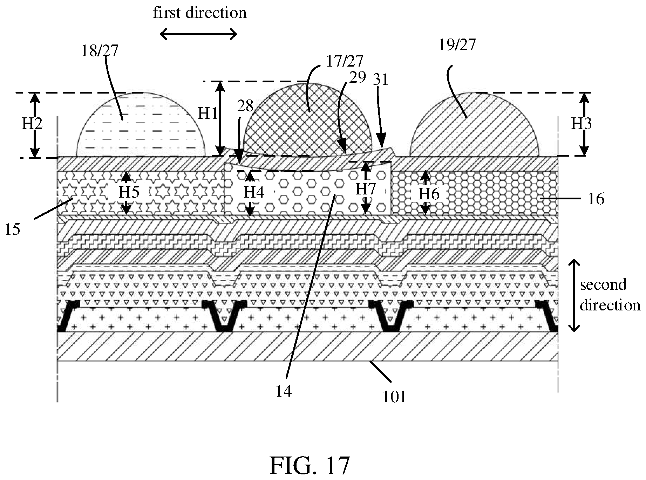

FIG. 15 is a first schematic diagram of preparation of a color filter layer of the present exemplary embodiment. FIG. 16 is a second schematic diagram of preparation of a color filter layer of the present exemplary embodiment. FIG. 17 is a schematic diagram of yet another display panel of the present exemplary embodiment. In some exemplary embodiments, as shown in FIGS. 14 to 16, at least one of the first color film layer 14, the second color film layer 15, and the third color film layer 16 may be provided with a fourth curved surface 28. For example, an end surface of the first color film layer 14 away from the base substrate 101 may be a curved surface, that is, the fourth curved surface 28. An end surface of the first lens 17 away from the base substrate 101 is a curved surface, that is, the first curved surface 23. An end surface of the first lens 17 close to the base substrate 101 is a curved surface, that is, the fifth curved surface 29. The fifth curved surface 29 and the fourth curved surface 28 are concentrically arranged. The fifth curved surface 29 may be formed by a material of the first lens 17 conforming to a topography of the fourth curved surface 28. Thereby the first lens 17 forms a convex lens structure at both ends in the first direction, and a height of the first lens 17 is larger than that of the other lenses. Meanwhile, the filling layer 4 is provided with a third curved surface 31. The third curved surface 31 can correspond to the fourth curved surface 28 and the fifth curved surface 29. An orthographic projection of the third curved surface 31 on the base substrate is within an orthographic projection of the fourth curved surface 28 on the base substrate. The third curved surface 31 is also formed by a material conforming to the topography of the fourth curved surface 28.

In some exemplary embodiments, as shown in FIGS. 13 to 16, light passing through the color filter layer 3 is filtered into monochromatic light. The monochromatic light is incident on the filling layer 4 through the fourth curved surface 28. A refractive index of the filling layer 4 is close to a refractive index of the first lens 17. The filling layer 4 gathers light through the third curved surface 31 to perform a first step of improving the brightness of the light. Subsequently, after the light has transmitted through the filling layer 4, it enters the first lens 17, which can amplify the brightness of the light again. As a result, the light transmits through the color filter layer 3 until it exits from the first lens 17, undergoing two brightness enhancement processes.

In some exemplary embodiments, as shown in FIGS. 14 to 16, the fourth curved surface 28 may be located on the first color film layer 14. An end of the fourth curved surface 28 close to the light-emitting substrate may be flush with ends of the second color film layer 15 and the third color film layer 16 away from the light-emitting substrate. That is, a thickness of middle of the first color film layer 14 may be a minimum thickness (H4) of the first color film layer 14, where H4 = H5 = H6. A maximum dimension of a circumferential margin of the first color film layer in the second direction is a first thickness (H7). The first thickness (H7) may be greater than a thickness (H5) of the second color film layer and a thickness (H6) of the third color film layer.

In some exemplary embodiments, as shown in FIGS. 14 to 16, in the process of preparing the color filter layer, the second color film layer 15 and the third color film layer 16 are first prepared and formed. A first gap 30 for preparing the first color film layer 14 is reserved between the second color film layer 15 and the third color film layer 16. Subsequently, the first color film layer 14 is formed. During formation of the first color film layer 14, the first color film layer 14 may cover portions of end surfaces of the second color film layer 15 and the third color film layer 16 away from the base substrate 101, so that two ends of a top portion of the first color film layer 14 in the second direction protrude relative to the middle portion, forming a recessed fourth curved surface 28.

In some exemplary embodiments, as shown in FIGS. 14 to 16, only the first lens 17 has the fifth curved surface 29, and neither the second lens 18 nor the third lens 19 has the fifth curved surface 29. But it is not limited thereto, for example, one of the second lens 18 and the third lens 19 also has the fifth curved surface 29. The height (H1) of the first lens 17, the height (H2) of the second lens 18, and the height (H3) of the third lens 19 may sequentially increase, that is, H1 > H2 > H3, so that the brightness amplification gain of the first lens 17, the brightness amplification gain of the second lens 18, and the brightness amplification gain of the third lens 19 may sequentially decrease. A difference between the height (H1) of the first lens 17 and the height (H2) of the second lens 18 is less than or equal to 1 micron. A difference between the height (H2) of the second lens 18 and the height (H3) of the third lens 19 is less than or equal to 1 micron. A ratio of the brightness amplification gain of the first lens 17 to the brightness amplification gain of the second lens 18 is configured to be 1 to 1.5. A ratio of the brightness amplification gain of the second lens 18 to the brightness amplification gain of the third lens 19 is configured to be 1 to 1.5.

In some exemplary embodiments, a preparation method, applied to the above-described display panel, includes forming a plurality of lenses. The process of forming the lens may be accomplished through a single preparation using a mask. The mask is designed differently according to opening sizes and light transmittances of the lenses corresponding to different pixels, so as to produce a plurality of lenses having different outer shapes. The above-mentioned mask can be a half-tone mask (HTM). HTM is a mask that uses a film with a certain optical transmittance to realize partial light transmission function. It is mainly used in the production of TFT panels. The half-tone mask can realize a graphic structure including full light transmission, complete opacity, and partial light transmission effects, and its graphic accuracy indexes are higher than those of other types of masks. The process of forming the lens can also be accomplished by forming different lenses in a plurality of steps, for example, forming one lens using one mask, and then forming another different lens using another mask, thus completing the preparation process of all lenses.

In some exemplary embodiments, a display device is provided, which includes the display panel of the embodiment described above. The display panel may be an OLED display panel with an integrated touch structure. The display device may be any products or components with display and touch functions, such as a mobile phone, a tablet computer, a television, a display, a laptop computer, a digital photo frame, or a navigator.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the essence and scope of the technical solutions of the present disclosure, and shall all fall within the scope of the claims of the present disclosure.

## Claims

1. A display panel, comprising:
a light-emitting substrate comprising a base substrate and a light-emitting structure that is configured to emit initial light;
a color filter layer disposed on the light-emitting substrate, wherein the color filter layer is configured to filter the initial light into a plurality of kinds of monochromatic light of different colors; and
a lens layer disposed on a side of the color filter layer away from the light-emitting substrate, wherein the lens layer is configured to amplify brightness of the plurality of kinds of monochromatic light and to compensate for brightness differences between the plurality of kinds of monochromatic light, the lens layer outputs a plurality of kinds of amplified light of different colors, and brightness differences between the plurality of kinds of amplified light are less than a preset difference.

2. The display panel according to claim 1, wherein the lens layer comprises a plurality of lenses arranged at intervals in a first direction, the plurality of lenses comprise at least one first lens and at least one second lens, the at least one first lens and the at least one second lens are configured to transmit the monochromatic light of different colors, a brightness amplification gain of the at least one first lens is greater than a brightness amplification gain of the at least one second lens, and the first direction is parallel to the light-emitting substrate.

3. The display panel according to claim 2, wherein the plurality of lenses further comprise at least one third lens, the monochromatic light transmitted by the at least one third lens is configured to have a different color from the monochromatic light transmitted by the at least one first lens and the at least one second lens;
wherein the brightness amplification gain of the at least one first lens is greater than a brightness amplification gain of the at least one third lens;
or, the brightness amplification gain of the at least one third lens is configured to be smaller than the brightness amplification gain of the at least one second lens.

4. The display panel according to claim 2, wherein an end surface of the at least one first lens away from the light-emitting substrate is a first curved surface, an end surface of the at least one second lens away from the light-emitting substrate is a second curved surface, and a curvature of the first curved surface is greater than a curvature of the second curved surface;
or, a maximum dimension of the at least one first lens in a second direction is configured to be larger than a maximum dimension of the at least one second lens in the second direction, and the second direction is perpendicular to the light-emitting substrate;
or, a maximum dimension of the at least one first lens in the first direction is configured to be larger than a maximum dimension of the at least one second lens in the first direction.

5. The display panel according to claim 3, wherein the color filter layer comprises a first color film layer configured to filter the initial light into a first monochromatic light, a second color film layer configured to filter the initial light into a second monochromatic light, and a third color film layer configured to filter the initial light into a third monochromatic light;
an orthographic projection of a first lens of the at least one first lens on the base substrate is within an orthographic projection of the first color film layer on the base substrate;
an orthographic projection of a second lens of the at least one second lens on the base substrate is within an orthographic projection of the second color film layer on the base substrate; and
an orthographic projection of a third lens of the at least one third lens on the base substrate is within an orthographic projection of the third color film layer on the base substrate.

6. The display panel according to claim 5, wherein the first monochromatic light is configured to be blue light and the second monochromatic light is configured to be red light or green light; and
a light transmittance of the first color film layer is smaller than a light transmittance of the second color film layer, and brightness of the first monochromatic light is smaller than brightness of the second monochromatic light.

7. The display panel according to claim 5, wherein the light-emitting structure comprises a first electrode and a pixel definition layer disposed sequentially in a direction away from the base substrate, and the color filter layer is disposed on a side of the pixel definition layer away from the base substrate; and
the pixel definition layer is provided with a plurality of pixel openings, a pixel opening of the plurality of pixel openings is configured to expose a portion of a surface of the first electrode, an orthographic projection of a lens of the plurality of lenses on the base substrate is within an orthographic projection of the pixel opening on the base substrate, and a center of the pixel opening and a center of the lens are collinear in a direction perpendicular to the base substrate.

8. The display panel according to claim 7, wherein a minimum distance between the at least one first lens and the at least one second lens in the first direction is configured to be equal to a minimum distance between the at least one first lens and the at least one third lens in the first direction.

9. The display panel according to claim 8, wherein the center of the pixel opening and a center of the first electrode are configured to be collinear in the direction perpendicular to the base substrate, and a minimum distance between the first color film layer and the at least one second lens in the first direction is configured to be equal to a minimum distance between the first color film layer and the at least one third lens in the first direction.

10. The display panel according to claim 8, wherein the center of the pixel opening and a center of the first electrode are non-collinear in the direction perpendicular to the base substrate;
the plurality of pixel openings comprise a first opening, a second opening, and a third opening, the orthographic projection of the first lens on the base substrate is within an orthographic projection of the first opening on the base substrate, the orthographic projection of the second lens on the base substrate is within an orthographic projection of the second opening on the base substrate, and the orthographic projection of the third lens on the base substrate is within an orthographic projection of the third opening on the base substrate; and
a spacing between a center of the first opening and a center of the second opening in the first direction is configured to be equal to a spacing between the center of the first opening and a center of the third opening in the first direction.

11. The display panel according to claim 7, wherein the center of the pixel opening and a center of the first electrode are non-collinear in the direction perpendicular to the base substrate;
the plurality of pixel openings comprise a first opening, a second opening, and a third opening, the orthographic projection of the first lens on the base substrate is within an orthographic projection of the first opening on the base substrate, the orthographic projection of the second lens on the base substrate is within an orthographic projection of the second opening on the base substrate, and the orthographic projection of the third lens on the base substrate is within an orthographic projection of the third opening on the base substrate;
the second opening and the third opening are disposed on two sides of the first opening in the first direction, and the second opening and the third opening are configured to be symmetrical about a center line of the first color film layer in the first direction; and
a minimum distance between the first color film layer and the at least one second lens in the first direction is configured to be equal to a minimum distance between the first color film layer and the at least one third lens in the first direction.

12. The display panel according to claim 5, wherein a thickness of the first color film layer, a thickness of the second color film layer, and a thickness of the third color film layer are configured to sequentially increase;
the brightness amplification gain of the at least one first lens, the brightness amplification gain of the at least one second lens, and the brightness amplification gain of the at least one third lens are configured to sequentially increase; and
the thickness of the first color film layer is configured to be a maximum dimension of the first color film layer in a second direction, the thickness of the second color film layer is configured to be a maximum dimension of the second color film layer in the second direction, the thickness of the third color film layer is configured to be a maximum dimension of the third color film layer in the second direction, and the second direction is perpendicular to the light-emitting substrate.

13. The display panel according to claim 12, wherein a thickness difference between the first color film layer and the second color film layer is configured to be less than or equal to 0.8 microns, and a thickness difference between the second color film layer and the third color film layer is configured to be less than or equal to 0.8 microns.

14. The display panel according to claim 12, wherein a maximum dimension of the at least one first lens in the first direction is a first width, a maximum dimension of the at least one second lens in the first direction is a second width, and a maximum dimension of the at least one third lens in the first direction is a third width; and
a difference between the first width and the second width is less than or equal to 1.5 microns, and a difference between the second width and the third width is configured to be less than or equal to 1.5 microns.

15. The display panel according to claim 5, further comprising a filling layer between the lens layer and the color filter layer.

16. The display panel according to claim 15, wherein the filling layer is configured to compensate for a height difference between the first color film layer, the second color film layer, and the third color film layer, and ends of the plurality of lenses close to the light-emitting substrate are located in a same plane parallel to the light-emitting substrate;
or, the filling layer is configured to compensate for a height difference between the at least one first lens, the at least one second lens, and the at least one third lens, and ends of the at least one first lens, the at least one second lens, and the at least one third lens away from the light-emitting substrate are located in the same plane parallel to the light-emitting substrate.

17. The display panel according to claim 15, wherein a refractive index of the filling layer is configured to be greater than a refractive index of the lens layer and less than a refractive index of the color filter layer.

18. The display panel according to claim 15, wherein the filling layer is provided with a third curved surface recessed toward the light-emitting substrate, an orthographic projection of at least one lens of the plurality of lenses on the base substrate is configured to overlap with an orthographic projection of the third curved surface on the base substrate, and the third curved surface is configured to gather monochromatic light transmitted through the filling layer toward the at least one lens.

19. The display panel according to claim 18, wherein a plurality of third curved surfaces are provided, the plurality of third curved surfaces are arranged in a direction parallel to the base substrate, and the plurality of third curved surfaces are provided as a plurality of curved surfaces having different curvatures.

20. The display panel according to claim 18, wherein at least one of the first color film layer, the second color film layer, and the third color film layer is provided with a fourth curved surface recessed toward the light-emitting substrate at an end surface away from the light-emitting substrate; and
the filling layer covers the fourth curved surface, and an orthographic projection of the fourth curved surface on the base substrate is configured to overlap with the orthographic projection of the third curved surface on the base substrate.

21. The display panel according to claim 18, wherein one of the plurality of lenses is configured to cover the third curved surface, and is provided with a fifth curved surface matching the third curved surface at an end surface close to the light-emitting substrate.

22. The display panel according to claim 20, wherein the fourth curved surface is disposed on the first color film layer, and an end of the fourth curved surface close to the light-emitting substrate is configured to flush with ends of the second color film layer and the third color film layer away from the light-emitting substrate; and
a maximum dimension of a circumferential margin of the first color film layer in a direction perpendicular to the base substrate is a first thickness, and the first thickness is configured to be larger than a thickness of the second color film layer and a thickness of the third color film layer.

23. The display panel according to claim 22, wherein a height of the at least one first lens, a height of the at least one second lens, and a height of the at least one third lens are configured to sequentially decrease;
the brightness amplification gain of the at least one first lens, the brightness amplification gain of the at least one second lens, and the brightness amplification gain of the at least one third lens are configured to sequentially decrease; and
the height of the at least one first lens is configured to be a maximum dimension of the at least one first lens in a direction perpendicular to the light-emitting substrate, the height of the at least one second lens is configured to be a maximum dimension of the at least one second lens in the direction perpendicular to the light-emitting substrate, and the height of the at least one third lens is configured to be a maximum dimension of the at least one third lens in the direction perpendicular to the light-emitting substrate.

24. The display panel according to claim 22, wherein a difference between a height of the at least one first lens and a height of the at least one second lens is less than or equal to 1 micron, and a difference between the height of the at least one second lens and a height of the at least one third lens is less than or equal to 1 micron; and
a ratio of the brightness amplification gain of the at least one first lens to the brightness amplification gain of the at least one second lens is configured to be 1 to 1.5, and a ratio of the brightness amplification gain of the at least one second lens to the brightness amplification gain of the at least one third lens is configured to be 1 to 1.5.

25. A display device, comprising the display panel according to any one of claims 1 to 24.
